(19) Europäisches Patentamt / European Patent Office / Office européen des brevets

(11) EP 3 648 265 A1

(12) EUROPÄISCHE PATENTANMELDUNG

(43) Veröffentlichungstag:
06.05.2020 Patentblatt 2020/19

(51) Int Cl.:
H01S 5/12 (2006.01)          H01S 5/34 (2006.01)
H01S 5/50 (2006.01)

(21) Anmeldenummer: 18203957.8

(22) Anmeldetag: 01.11.2018

(84) Benannte Vertragsstaaten:
AL AT BE BG CH CY CZ DE DK EE ES FI FR GB
GR HR HU IE IS IT LI LT LU LV MC MK MT NL NO
PL PT RO RS SE SI SK SM TR
Benannte Erstreckungsstaaten:
BA ME
Benannte Validierungsstaaten:
KH MA MD TN

(71) Anmelder: Technische Universität Berlin
10623 Berlin (DE)

(72) Erfinder:
• GREIF, Ludwig
10587 Berlin (DE)
• SCHLIWA, Andrei
15859 Storkow (DE)

(74) Vertreter: Fischer, Uwe
Patentanwalt
Moritzstraße 22
13597 Berlin (DE)

(54) OPTISCHER HALBLEITERVERSTÄRKER

(57) Die Erfindung bezieht sich unter anderem auf einen optischen Halbleiterverstärker (10), bei dem eine Vielzahl an Quantenpunkten (QD) in zumindest einer Quantenpunktschicht (21-24) eines Halbleiterelements (11) des Halbleiterverstärkers (10) angeordnet sind, wobei das Halbleiterelement (11) eine in der Quantenpunktschichtebene liegende Vorzugsrichtung (X) aufweist und elongierte Quantenpunkte (QD) vorhanden sind, die jeweils in der genannten Vorzugsrichtung (X) länger sind als in einer dazu senkrechten und ebenfalls in der Quantenpunktschichtebene liegenden Querrichtung (Y).

Erfindungsgemäß ist vorgesehen, dass die Strahlverstärkungsrichtung (SVR) des Halbleiterverstärkers (10), die durch eine fiktive Verbindungslinie (VL) zwischen einem zum Einstrahlen von Eingangsstrahlung (Se) dienenden Eingang (A10) des Halbleiterverstärkers (10) und einem zum Ausgeben der verstärkten Strahlung (Sa) dienenden Ausgang (A10) des Halbleiterverstärkers (10) festgelegt wird, parallel oder zumindest näherungsweise parallel zu der Querrichtung (Y) angeordnet ist.

Fig.2

**Beschreibung**

Die Erfindung bezieht sich auf optische Halbleiterverstärker, ein Verfahren zum Herstellen optischer Halbleiterverstärker sowie auf ein Verfahren zum Betreiben eines optischen Halbleiterverstärkers.

Das europäische Patent EP 1 354 338 B1 offenbart einen optischen Halbleiterverstärker mit den Merkmalen gemäß dem Oberbegriff des Patentanspruchs 1, also einen Halbleiterverstärker, bei dem eine Vielzahl an Quantenpunkten in einer Quantenpunktschicht eines Halbleiterelements des Halbleiterverstärkers angeordnet sind, wobei das Halbleiterelement eine in der Quantenpunktschichtebene liegende Vorzugsrichtung aufweist und elongierte Quantenpunkte vorhanden sind, die jeweils in der genannten Vorzugsrichtung länger sind als in einer dazu senkrechten und ebenfalls in der Quantenpunktschichtebene liegenden Querrichtung.

Der Erfindung liegt die Aufgabe zugrunde, einen Halbleiterverstärker anzugeben, der eine besonders hohe Verstärkung aufweist.

Diese Aufgabe wird erfindungsgemäß durch einen optischen Halbleiterverstärker mit den Merkmalen gemäß Patentanspruch 1 gelöst. Vorteilhafte Ausgestaltungen des erfindungsgemäßen Halbleiterverstärkers sind in Unteransprüchen angegeben.

Danach ist erfindungsgemäß vorgesehen, dass die Strahlverstärkungsrichtung des Halbleiterverstärkers, die durch eine fiktive Verbindungslinie zwischen einem zum Einstrahlen von Eingangsstrahlung dienenden Eingang des Halbleiterverstärkers und einem zum Ausgeben der verstärkten Strahlung dienenden Ausgang des Halbleiterverstärkers festgelegt wird, parallel oder zumindest näherungsweise parallel zu der Querrichtung angeordnet ist.

Ein wesentlicher Vorteil des erfindungsgemäßen Halbleiterverstärkers besteht in seiner hohen Verstärkung, die auf der erfindungsgemäß vorgesehenen Ausrichtung der elongierten Quantenpunkte beruht.

Als vorteilhaft wird es angesehen, wenn bei mehr als 50 % der elongierten Quantenpunkte die Länge in der Vorzugsrichtung mindestens das 1,5-fache, vorzugsweise zwischen dem 1,8-fachen und dem 2,4-fachen, der Länge der Quantenpunkte in der Querrichtung beträgt.

Vorzugsweise sind mindestens zwei zueinander parallele Quantenpunktschichten mit jeweils einer Vielzahl an elongierten Quantenpunkten vorhanden.

Die Quantenpunkte liegen vorzugsweise fluchtend übereinander. Die jeweils übereinander liegenden Quantenpunkte bilden vorzugsweise elongierte Quantenpunktsäulen.

Die Quantenpunkte sind in den elongierten Quantenpunktsäulen vorzugsweise quantenmechanisch gekoppelt.

Bei einer bevorzugten Ausgestaltung ist vorgesehen, dass die übereinander liegende Quantenpunkte einander berühren.

Alternativ können die übereinander liegenden Quantenpunkte auch durch eine oder mehrere Trennschichten voneinander getrennt sein; die Trennschichten sind vorzugsweise so dünn, dass die quantenmechanische Kopplung der Quantenpunkte erhalten bleibt.

Das Verhältnis zwischen der Höhe der Quantenpunktsäulen und der Länge der Säulengrundfläche in Vorzugsrichtung beträgt vorzugsweise jeweils 1 oder liegt vorzugsweise zumindest in einem Bereich zwischen 0,9 und 1,1.

Die Längsrichtung der Quantenpunktsäulen erstreckt sich vorzugsweise in der [001]-Kristallrichtung.

Die genannte Vorzugsrichtung ist vorzugsweise die [1$\bar{1}$0] - Kristallrichtung.

Die genannte Querrichtung ist vorzugsweise die [110]-Kristallrichtung.

Bei einer bevorzugten Ausführungsvariante ist vorgesehen, dass bei jeder der Quantenpunktschichten jeweils mindestens 50 % der Quantenpunkte eine Länge in der Vorzugsrichtung aufweisen, die mindestens das 1,5-fache der Länge der elongierten Quantenpunkte in der Querrichtung beträgt.

Die Strahlverstärkungsrichtung liegt vorzugsweise in der Quantenpunktschicht bzw. den Quantenpunktschichten oder zumindest näherungsweise in oder parallel zu der Quantenpunktschicht bzw. Quantenpunktschichten.

Der Fehlwinkel zwischen der Strahlverstärkungsrichtung und der Querrichtung und der Fehlwinkel zwischen der Strahlverstärkungsrichtung und der Quantenpunktschicht sind vorzugsweise jeweils kleiner als 1°.

Die Länge der Quantenpunkte ist in der Vorzugsrichtung gesehen vorzugsweise kleiner als 40 nm und/oder kleiner als die DeBroglie-Wellenlänge der Elektronen im Quantenpunktmaterial. Die Quantenpunkte sind folglich vorzugsweise keine Quantendrähte.

Die Erfindung bezieht sich darüber hinaus auf ein Verfahren zum Herstellen eines optischen Halbleiterverstärkers, insbesondere zum Herstellen eines optischen Halbleiterverstärkers, wie er oben beschrieben worden ist oder in den Patentansprüche definiert ist, wobei bei dem Verfahren eine Vielzahl an Quantenpunkten hergestellt wird, indem Quantenpunktmaterial auf einer Schicht des Halbleiterelements aufgebracht wird und eine Strahlverstärkungsrichtung des Halbleiterverstärkers durch eine fiktive Verbindungslinie zwischen einem zum Einstrahlen von Eingangsstrahlung dienenden Eingang des Halbleiterverstärkers und einem zum Ausgeben der verstärkten Strahlung dienenden Ausgang des Halbleiterverstärkers festgelegt wird.

Bezüglich eines solchen Verfahrens ist erfindungsgemäß vorgesehen, dass die Mehrzahl der Quantenpunkte als elongierte Quantenpunkte hergestellt werden, die in einer in der Quantenpunktschichtebene liegenden Vorzugsrichtung des Halbleiterelements länger als in einer dazu senkrechten und ebenfalls in der Quantenpunktschichtebene liegenden Querrichtung sind, und die Strahlverstärkungsrichtung parallel oder zumindest näherungsweise parallel zu dieser Querrichtung angeordnet wird.

Bezüglich der Vorteile des erfindungsgemäßen Verfahrens sei auf die obigen Ausführungen im Zusammenhang mit dem erfindungsgemäßen Halbleiterverstärker verwiesen.

Vorteilhaft ist es, wenn bei mehr als 50 % der Quantenpunkte die Länge in der Vorzugsrichtung des Halbleiterelements mindestens 1,5-mal größer als in der Querrichtung hergestellt wird.

Bei einer als besonders vorteilhaft angesehenen Ausführungsvariante ist vorgesehen, dass Quantenpunktmaterial zur Bildung der Quantenpunkte mittelbar oder unmittelbar auf ein (001)-Substrat aufgewachsen wird und als Wachstumsrichtung beim Aufbringen des Quantenpunktmaterials die [001]-Kristallrichtung ausgewählt wird, die Vorzugsrichtung des Halbleiterelements die [1$\bar{1}$0]-Kristallrichtung ist und die Querrichtung die [110]-Kristallrichtung ist.

Vorzugsweise wird eine Quantenpunktsäulenschicht mit mindestens zwei zueinander parallelen Quantenpunktschichten mit jeweils einer Vielzahl an elongierten Quantenpunkten hergestellt. Die Quantenpunkte werden vorzugsweise fluchtend übereinander aufgewachsen und die jeweils übereinander liegenden Quantenpunkte bilden vorzugsweise entlang der Vorzugsrichtung elongierte Quantenpunktsäulen.

Die Quantenpunkte in den elongierten Quantenpunktsäulen werden vorzugsweise ohne Abstand zueinander oder mit einem nur geringen Abstand zueinander hergestellt. Im Falle eines Abstands zwischen unmittelbar übereinander liegenden Quantenpunkten wird der Abstand vorzugsweise derart klein gewählt, dass die Quantenpunkte quantenmechanisch gekoppelt sind.

Bei einer besonders bevorzugten Variante ist vorgesehen, dass die Quantenpunkte in den elongierten Quantenpunktsäulen unmittelbar aufeinander aufgewachsen werden, so dass sich diese berühren. Alternativ können auch Trennschichten vorgesehen werden; diese sind vorzugsweise jedoch jeweils alle oder gemeinsam so dünn, dass eine quantenmechanische Kopplung der Quantenpunkte erreicht wird bzw. erhalten bleibt.

Das Verhältnis zwischen der Höhe der Quantenpunktsäulen und der Länge der Säulengrundfläche in Querrichtung wird vorzugsweise auf einen Wert von 1 oder zumindest auf einen Wert im Bereich zwischen 0,9 und 1,1 eingestellt.

Die Längsrichtung der Quantenpunktsäulen erstreckt sich vorzugsweise in der [001]-Kristallrichtung.

Die Quantenpunkte werden vorzugsweise aufgewachsen.

Die Wachstumstemperatur wird beim Aufwachsen der Quantenpunkte vorzugsweise größer als 500 °C eingestellt.

Die Wachstumsrate beim Aufwachsen der Quantenpunkte wird vorzugsweise größer 0,2 pm/h eingestellt.

Auch ist es vorteilhaft, wenn eine Barriereschicht von mindestens 10 nm hergestellt wird, um den Betriebs- bzw. Injektionsstrom gezielt in den Bereich der Quantenpunktsäulen zu lenken und dort eine besonders hohe Stromdichte zu erzielen.

Als elongierte Quantenpunkte werden vorzugsweise selbstorganisierte InAs-Quantenpunkte mit metallorganischer Gasphasenepitaxie oder Molekularstrahlepitaxie aufgewachsen.

Die Quantenpunkte werden in der Vorzugsrichtung gesehen vorzugsweise kürzer als 40 nm und/oder kürzer als die DeBroglie-Wellenlänge der Elektronen im Quantenpunktmaterial hergestellt.

Vorteilhaft ist es, wenn mindestens zwei, insbesondere zwischen 5 und 10, zueinander parallele Quantenpunktschichten mit jeweils einer Vielzahl an Quantenpunkten hergestellt werden, wobei bei jeder der Quantenpunktschichten jeweils mindestens 50 % der elongierten Quantenpunkte eine Länge in der Vorzugsrichtung aufweisen, die mindestens das 1,5-fache der Länge der Quantenpunkte in der Querrichtung beträgt.

Die Strahlverstärkungsrichtung liegt vorzugsweise in der Quantenpunktschicht oder in den Quantenpunktschichtn oder zumindest näherungsweise in oder parallel zu der Quantenpunktschicht oder den Quantenpunktschichten.

Der Fehlwinkel zwischen der Strahlverstärkungsrichtung und der Querrichtung und der Fehlwinkel zwischen der Strahlverstärkungsrichtung und der Quantenpunktschicht werden vorzugsweise jeweils kleiner als 1° eingestellt.

Die Erfindung bezieht sich darüber hinaus auf ein Verfahren zum Betreiben eines optischen Halbleiterverstärkers, insbesondere eines optischen Halbleiterverstärkers, wie er oben beschrieben worden ist oder in den Patentansprüchen definiert ist. Erfindungsgemäß ist vorgesehen, dass optische Strahlung an dem Eingang des Halbleiterverstärkers entlang einer Richtung mit einem Fehlwinkel von weniger als 30° bezogen auf die Querrichtung der elongierten Quantenpunkte eingestrahlt wird und die verstärkte Strahlung entlang dieser Strahlrichtung am Ausgang des Halbleiterverstärkers aus diesem ausgekoppelt wird.

Bezüglich der Vorteile des letztgenannten Verfahrens sei auf die obigen Ausführungen im Zusammenhang mit dem erfindungsgemäßen Halbleiterverstärker verwiesen.

Die Erfindung wird nachfolgend anhand von Ausführungsbeispielen näher erläutert; dabei zeigen beispielhaft

Figur 1     ein Ausführungsbeispiel für einen erfindungsgemäßen optischen Halbleiterverstärker in einer dreidimensionalen Sicht schräg von der Seite,

Figur 2     einen Längsschnitt durch den Halbleiterverstärker gemäß Figur 1 zur beispielhaften Darstellung von Quantenpunktsäulen in einer

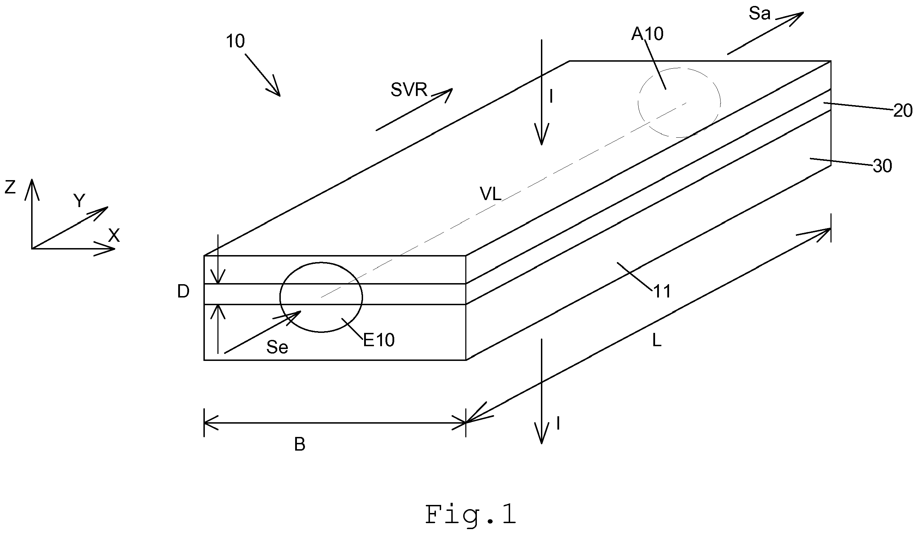

Quantenpunktsäulenschicht des Halbleiterverstärkers gemäß Figur 1,

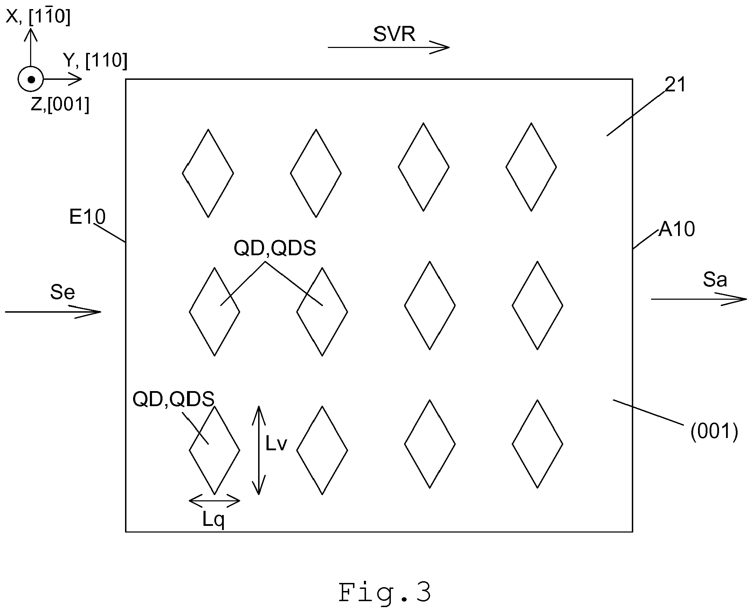

Figur 3     eine Draufsicht auf eine Quantenpunktschicht der Quantenpunktsäulenschicht bei dem Halbleiterverstärker gemäß Figur 1,

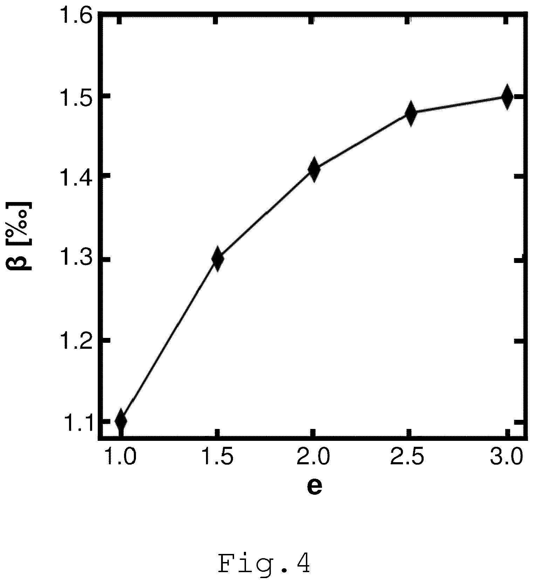

Figur 4     den β-Faktor in Abhängigkeit von der Elongation e,

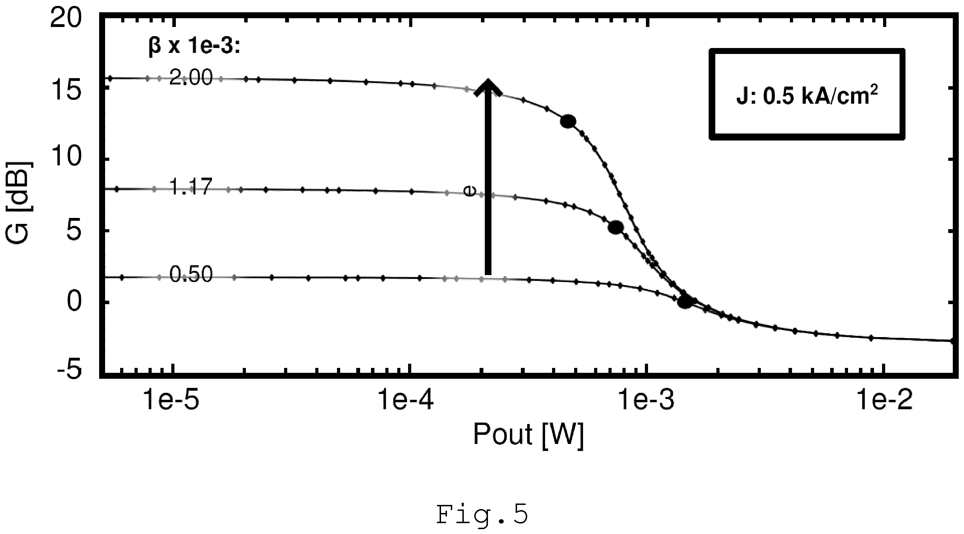

Figur 5     die Verstärkung G als Funktion der optischen Ausgangsleistung Pout für einen Injektionsstrom mit einer Stromdichte von J=0,5 kA/cm² und verschiedene β-Faktoren,

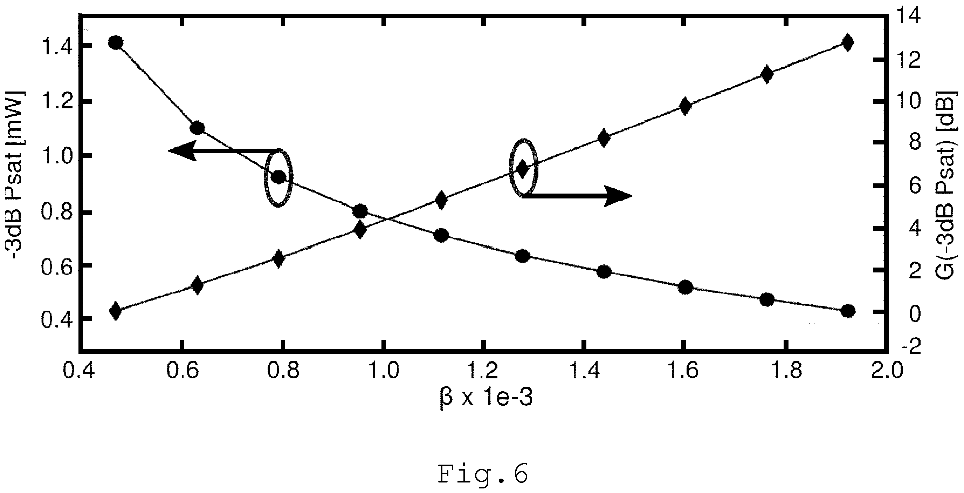

Figur 6     die 3dB Sättigungsleistung -3db Psat und die 3dB Sättigungsverstärkung G(-3dB Psat) als Funktion des β-Faktors,

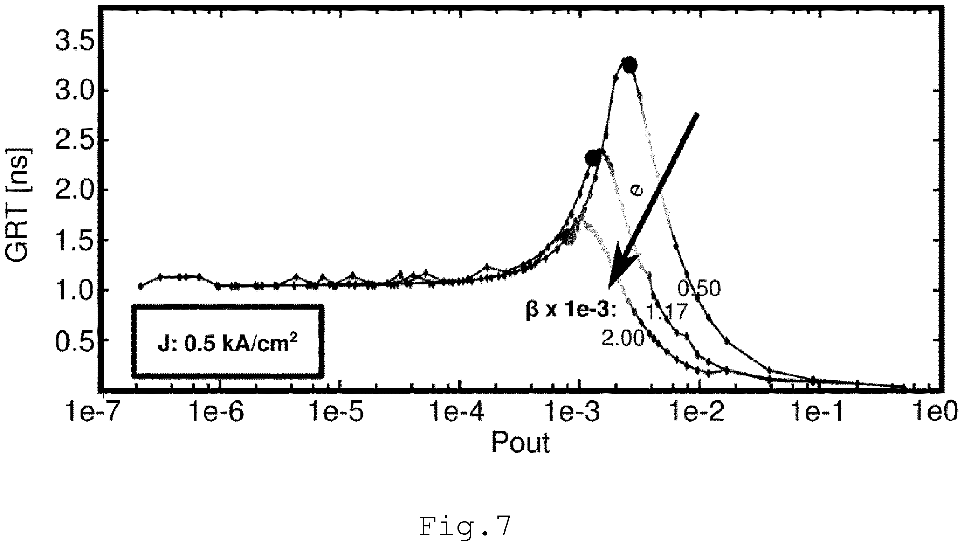

Figur 7     die Erholungszeit GRT über der optischen Ausgangsleistung Pout in Abhängigkeit von der Elongation e für einen Injektionsstrom mit einer Stromdichte von J=0,5 kA/cm² und

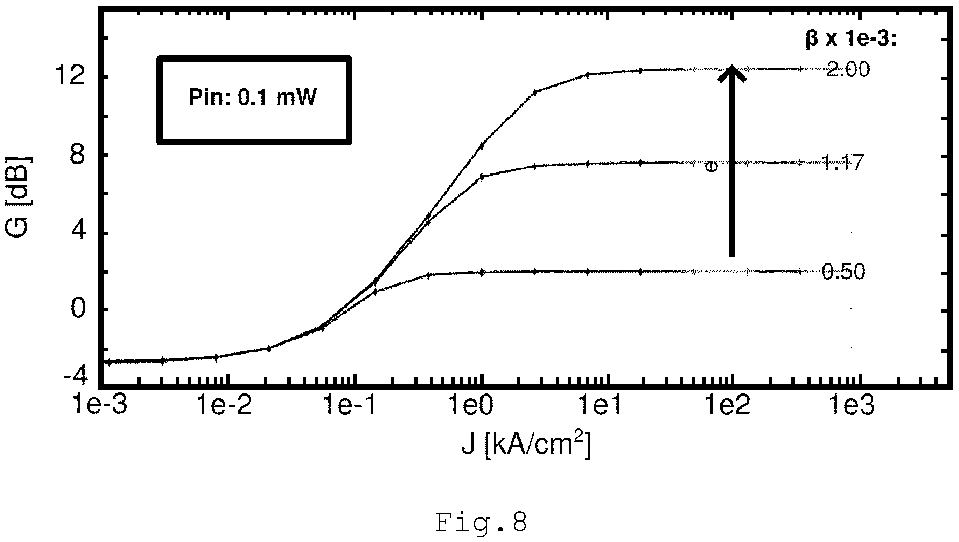

Figur 8     die Verstärkung G als Funktion der Injektionsstromdichte J für eine optische Eingangsleistung von 0,1 mW und verschiedene β-Faktoren.

In den Figuren werden der Übersicht halber für identische oder vergleichbare Komponenten stets dieselben Bezugszeichen verwendet.

Die Figur 1 zeigt in einer dreidimensionalen Sicht schräg von der Seite ein Ausführungsbeispiel für einen quantenpunktbasierten optischen Halbleiterverstärker (nachfolgend auch kurz als QD-SOA bezeichnet) 10, der einen optischen Eingang E10 zum Einstrahlen optischer Eingangsstrahlung Se aufweist. Entlang einer Strahlverstärkungsrichtung SVR fluchtend mit dem Eingang E10 befindet sich ein optischer Ausgang A10 des Halbleiterverstärkers 10, an dem verstärkte optische Strahlung Sa ausgangsseitig ausgegeben wird. Die fiktive Verbindungslinie zwischen dem Eingang E10 und dem Ausgang A10 ist in der Figur 1 mit dem Bezugszeichen VL gekennzeichnet.

Zum Zwecke der optischen Verstärkung der Eingangsstrahlung Se weist der optische Halbleiterverstärker 10 ein Halbleiterelement 11 mit einer Quantenpunktsäulenschicht 20 auf, die mittelbar oder unmittelbar, wie beispielhaft in der Figur 1 gezeigt, auf einem Substrat 30 des Halbleiterelements 11 aufliegt bzw. aufgewachsen ist.

Der optische Halbleiterverstärker 10 gemäß Figur 1 wird vorzugsweise wie folgt betrieben:
Von außen wird ein elektrisches Feld angelegt, um einen elektrischen Strom I durch die Quantenpunktsäulenschicht 20 hervorzurufen. Der Strom I fließt senkrecht zur Schichtebene der Quantenpunktsäulenschicht 20 und versorgt die in der Quantenpunktsäulenschicht 20 befindlichen Quantenpunkte mit Energie zum Verstärken der Eingangsstrahlung Se. Die optische Eingangsstrahlung Se wird parallel oder zumindest näherungsweise parallel zur fiktiven Verbindungslinie L zwischen dem Eingang E10 und dem Ausgang A10 des Halbleiterverstärkers bzw. parallel zu der Strahlverstärkungsrichtung SVR eingestrahlt.

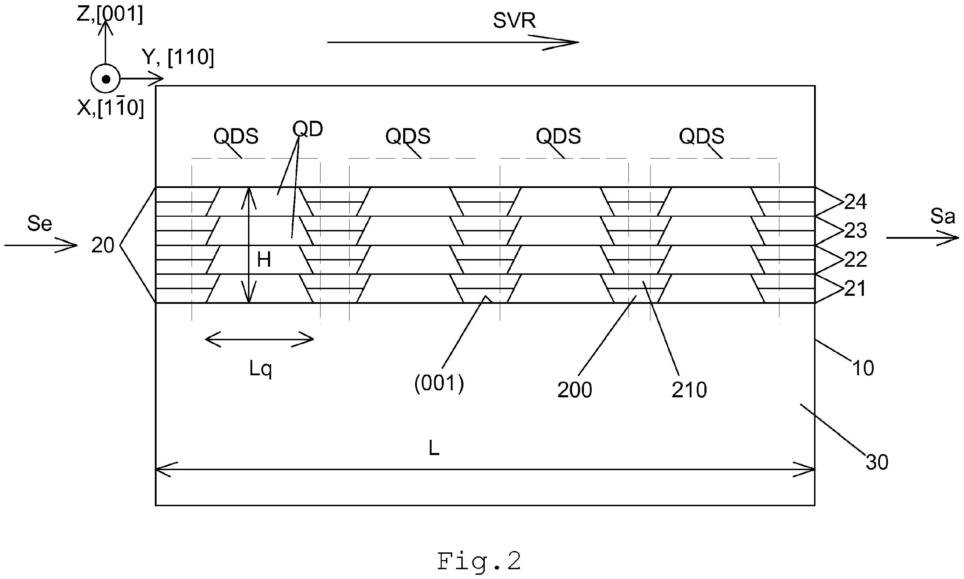

Die Figur 2 zeigt einen Längsschnitt durch den optischen Halbleiterverstärker 10 näher im Detail. Man erkennt das Substrat 30 sowie die darauf befindliche Quantenpunktsäulenschicht 20. Die Quantenpunktsäulenschicht 20 umfasst eine Vielzahl an Quantenpunktschichten, von denen in der Figur 2 vier beispielhaft dargestellt und mit den Bezugszeichen 21, 22, 23 und 24 gekennzeichnet sind.

Jede der Quantenpunktschichten 21, 22, 23 und 24 weist jeweils eine Vielzahl an Quantenpunkten QD auf, die bzw. deren Grundfläche entlang einer in den Figuren 1 und 2 mit dem Bezugszeichen X gekennzeichneten Vorzugsrichtung länger als in der dazu senkrechten und ebenfalls in der Ebene der Quantenpunktschichten 21 bis 24 bzw. der Ebene der Quantenpunktsäulenschicht 20 liegenden Querrichtung Y, die der Strahlverstärkungsrichtung SVR gemäß Figur 1 entspricht, sind.

Die Quantenpunkte QD in den Quantenpunktschichten 21 bis 24 sind fluchtend übereinander angeordnet, so dass sich Quantenpunktsäulen QDS bilden, die jeweils übereinanderliegende Quantenpunkte QD aufweisen.

Bei dem Ausführungsbeispiel gemäß Figur 2 liegen die Quantenpunkte QD einer jeden Quantenpunktsäule QDS unmittelbar übereinander bzw. aufeinander und sind durch keine Zwischenschicht voneinander getrennt. Durch das unmittelbare Aufeinanderliegen der Quantenpunkte QD der Quantenpunktsäulen QDS kommt es zu einer quantenmechanischen Kopplung der Quantenpunkte innerhalb der jeweiligen Quantenpunktsäule QDS.

Alternativ können die Quantenpunktschichten 21 bis 24 auch weitere Schichten aufweisen, die zu einer räumlichen Trennung der Quantenpunkte QD voneinander in der jeweiligen Quantenpunktsäule QDS führen; bei einer solchen Ausführungsform ist es jedoch vorteilhaft, wenn die Trennschichten zwischen den unmittelbar übereinander liegenden Quantenpunkten QD jeweils so dünn sind, dass es bei der quantenmechanischen Kopplung der Quantenpunkte QD in jeder der Quantenpunktsäulen QDS bleibt, wie dies bei unmittelbar aufeinanderliegenden Quantenpunkten QD der Fall ist.

Jede der Quantenpunktschichten 21 bis 24 umfasst vorzugsweise jeweils eine untere Benetzungsschicht 200, welche mit den Quantenpunkten aufgewachsen werden und eine darauf befindliche Barriereschicht 210.

Das Material der unteren Benetzungsschichten 200 und das Quantenpunktmaterial der darauf befindlichen Quantenpunkte QD sind vorzugsweise jeweils identisch, wie in der Figur 2 gezeigt, so dass im Bereich der Quantenpunkte QD der jeweils dort befindliche Schichtabschnitt der Benetzungsschicht 200 selbst den unteren Teil des jeweiligen Quantenpunkts QD bildet.

Das Material der Barriereschichten 210 hat vorzugsweise eine größere Bandlücke als das Quantenpunktmaterial, so dass es zu einem vertikalen Strom I (vgl. Figur 1) durch die Quantenpunktsäulenschicht 20 ausschließlich oder zumindest überwiegend nur im Bereich der Quantenpunkte QD bzw. Quantenpunktsäulen QDS kommt.

Die Höhe der Quantenpunktsäulen QDS bzw. die Schichtdicke der Quantenpunktsäulenschicht 20 ist in der Figur 2 mit dem Bezugszeichen H gekennzeichnet. Die Länge der einzelnen Quantenpunkte QD in der Vorzugsrichtung X ist mit dem Bezugszeichen Lv gekennzeichnet. Das Verhältnis zwischen der Höhe H der Quantenpunktsäulen QDS und der Länge Lv der Quantenpunkte QD in der Vorzugsrichtung X liegt vorzugsweise in einem Bereich zwischen 0.9 und 1,1. Besonders bevorzugt beträgt das Verhältnis 1 oder zumindest näherungsweise 1.

Die Elongation der Quantenpunkte QD, auf die im Zusammenhang mit den Figuren 4 bis 8 weiter unten noch näher eingegangen wird, wird für die Darstellung in der Figur 4 wie folgt definiert:

$$e = Lv/Lq$$

wobei e die Elongation bezeichnet. Die Längen Lv und Lq beziehen sich jeweils auf die untere Grundfläche der Quantenpunkte QD, die die Unterseite der jeweiligen Quantenpunktschicht 21 bis 24 selbst bildet oder dieser zugewandt ist, falls sie diese nicht selbst bildet, sondern durch eine zusätzliche Trennschicht von dieser getrennt ist.

Als besonders vorteilhaft wird es angesehen, wenn die Kristallebene des Substrats 30, auf dem sich die Quantenpunktsäulenschicht 20 befindet, eine (001)-Kristallebene ist. Außerdem ist es vorteilhaft, wenn die genannte Vorzugsrichtung X, entlang derer die Quantenpunkte QD elongiert sind, durch die [1$\bar{1}$0]-Kristallrichtung des Substrats 30 bzw. des darauf befindlichen Schichtmaterials der Quantenpunktsäulenschicht 20 gebildet ist und es sich bei der Querrichtung Y um eine [110]-Kristallrichtung handelt.

Das Substrat 30 ist vorzugsweise ein GaAs-Substrat. Das Quantenpunktmaterial ist vorzugsweise InAs oder $In_xGA_{(x-1)}As$-Material.

Die Figur 3 zeigt die Quantenpunktschicht 21 der Quantenpunktsäulenschicht 20 des Halbleiterverstärkers 10 gemäß den Figuren 1 und 2 in einer Draufsicht. Es lassen sich die Quantenpunkte QD der Quantenpunktschicht 21 erkennen. Man sieht, dass die Quantenpunkte QD entlang der Vorzugsrichtung X (hier die [1$\bar{1}$0]-Kristallrichtung) länger sind als in der Querrichtung Y (hier die [110]-Kristallrichtung). Das Verhältnis zwischen der Länge Lv entlang der Vorzugsrichtung X und der Länge Lq entlang der Querrichtung Y beträgt vorzugsweise 1,5 oder mehr, besonders bevorzugt zwischen 1,8 und 2,4.

Durch die in der Figur 3 gezeigte Ausrichtung der elongierten Quantenpunkte QD relativ zur Strahlverstärkungsrichtung SVR bzw. zur fiktiven Linie VL zwischen dem Eingang E10 und dem Ausgang A10 des optischen Verstärkers 10 kommt es dazu, dass die optische Strahlung Se beim Passieren des optischen Halbleiterverstärkers 10 die Quantenpunkte QD jeweils entlang der Querrichtung Y durchläuft, wodurch relevante Vorteile erzielt werden können, was nachfolgend beispielhaft näher erläutert wird.

Durch die bei dem Ausführungsbeispiel gemäß den Figuren 1 bis 3 starke Elongation steigt die Wahrscheinlichkeit einer Abstrahlung von Photonen senkrecht zu der elongierten Achse X deutlich an. Da dies ebenfalls für die Wahrscheinlichkeit einer stimulierten Emission gilt, lässt sich hierdurch die Verstärkung des gesamten Halbleiterverstärkers 10 erhöhen.

Durch die Elongation der Quantenpunkte kommt es nämlich in der (001)-Ebene zu einem strukturellen Symmetriebruch. In der Folge richten sich Real- und Imaginärteil des komplexen Übergangsdipolmomentes μ zunehmend parallel an der elongierten Achse X aus. Die Wahrscheinlichkeit eines Überganges des angeregten Elektrons in den Grundzustand durch spontane Emissionen B21 ist gemäß Fermis goldener Regel proportional zur Ausrichtung der Photonenpolarisation und des Übergangsdipolmomentes:

$$B21 \propto (\underline{\varepsilon}\ \underline{\mu})^2$$

Somit werden, je nach Ausprägung der Elongation, elektronische Übergänge unter Mitwirkung von Photonen mit einer Polarisation entlang der Vorzugsrichtung X bevorzugt bzw. andersartige Polarisationen werden nahezu vollständig unterdrückt. Da die Propagationsrichtung von Photonen senkrecht auf ihrer Polarisation steht, hat eine Bevorzugung der Polarisation entlang der elongierten Achse, also der Vorzugsrichtung X, eine bevorzugte Ausbreitung in der dazu senkrechten Ebene zur Folge. Da darüber hinaus gilt, dass die Wahrscheinlichkeit für eine stimulierte Emission A21 proportional zu B21 ist, zieht dies auch die Steigerung der Wahrscheinlichkeit einer stimulierten Emission mit entsprechender Propagationsrichtung nach sich.

Theoretischer Hintergrund und Modellierung

Erfinderseitig erfolgte eine Simulation der elektronischen und optischen Eigenschaften von gestapelten InAs Quantenpunkten in GaAs mit Hilfe eines 8-Band kp-Models unter Berücksichtigung des Einflusses der Kristallverzerrung sowie der daraus resultierenden piezoelektrischen Felder in erster und zweiter Ordnung. Auf Basis der elektronischen Eigenschaften wurde die Abstrahlcharakteristik der spontanen Emission für die gestapelten Quantenpunkte berechnet. Dies bedeutet, dass basierend auf der konkreten geometrischen Struktur der gestapelten Quantenpunkte die Rate an spontan emittierten Photonen in Abhängigkeit eines einzelnen Raumwinkelelements ermittelt wurde. Der gesamte Raumwinkel wurde dabei durch 10 000 äquidistant verteilte Stützpunkte aufgelöst. Durch geometrische Überlegungen konnte anschließend in Abhängigkeit eines Satzes an Bauteildimensionen eines exemplarischen Bauteils der Anteil β der Photonen ermittelt werden, welcher innerhalb der aktiven Zone des Verstärkers propagiert und das Bauteil verlassen kann. Dieser fand Eingang in ein erweitertes Ben-Ezra Ratengleichungsmodell für QD-SOAs (Quantenpunkt-Halbleiterverstärker), in welchem die β-abhängige Rate stimulierter Emissionen eingearbeitet wurde. Mit Hilfe eines Runge-Kutta-Verfahrens vierter Ordnung wurde das Ratengleichungsmodell genutzt, um ein Pump-Probe Experiment für eine Vielzahl von unterschiedlichen Signalleistungen und die zuvor ermittelten β-Werte zu simulieren. Aus den Daten ließen sich folgende Werte als Funktion von β, der Signalausgangsleistungen und der Injektionsstromdichte J bestimmen:

- die Verstärkung G,
- die 3-dB Sättigungsleistung -3dB Psat
- die 3-dB Sättigungsverstärkung G(-3dB Psat) (kanonischer Index für die obere Grenze fehlerfrei verstärkter Signalleistung) und
- die Erholungszeit GRT (gain recovery time - GRT).

Die Simulation erfolgte dabei konkret für einen optischen Quantenpunkt-Halbleiterverstärker (QD-SOA) mit folgenden beispielhaften Bauteilangaben:

Quantenpunktebenen (Anzahl der Quantenpunktschichten innerhalb einer Quantenpunktssäulenschicht 20 gemäß den Figuren 1 bis 3): 7

- Länge L der aktiven Zone: entlang der Strahlverstärkungsrichtung SVR bzw. der Querrichtung Y: 2 mm
- Höhe H der aktiven Zone bzw. Schichtdicke der Quantenpunktsäulenschicht 20: 0.2 $\mu$m
- Breite B der aktiven Zone bzw. der Quantenpunktsäulenschicht in der Vorzugsrichtung X: 10 $\mu$m
- Quantenpunktdichte $5*10^{10}$ cm$^{-2}$
- Injektionsstromdichte J: $1*10^{-3}$ kA/cm$^2$ bis $1*10^3$ kA/cm$^2$
- Eingangssignalleistung Pin : $1*10^{-7}$ W bis 1 W

Ohne Beschränkung der Allgemeinheit wird im Folgenden beispielhaft der Einfluss der Elongation bei senkrechter Ausrichtung der optischen und elongierten Achse X für einen optischen InGaAs-Quantenpunkt-Halbleiterverstärker, nachfolgend auch InGaAs-QD-SOA genannt, vorgestellt. Zur Berechnung der β-Koeffizienten, welche von der QD-SOA-Simulation unabhängig verläuft, wurde eine Serie von fünf gestapelten InAs/GaAs-Quantenpunkten bzw. Quantenpunktsäulen berechnet, deren Elongation e zwischen 1 und 3 liegt (siehe Figur 4). Die Anzahl der gestapelten Quantenpunkte wird dabei nicht variiert, da diese in aller Regel durch die Absicht der Polarisationsunabhängigkeit in den Verstärkungseigenschaften festgelegt ist. Die hier beispielhaft vorgenommene Reduktion auf vier Quantenpunkte liegt an der deutlich reduzierten Rechenzeit und der Tatsache, dass umfangreiche Rechnungen, die im Rahmen der Forschungsarbeiten in der erfinderseitigen Arbeitsgruppe vorgenommen wurden, nahelegen, dass die Anzahl der gestapelten Quantenpunkte keinen signifikanten Einfluss auf die optischen Eigenschaften in der (001)-Ebene hat.

Die Ergebnisse in der Figur 4 zeigen, dass sich die Rate stimulierter Emissionen und folglich ebenso des β-Faktors im Rahmen der betrachteten Elongationen um beinahe 36 % steigern lässt. Es wurde festgestellt, dass bei orthogonal ausgerichteter optischer und elongierter Achse X eine größere Elongation auch einen höheren β-Faktor nach sich zieht. Nutzt man die gleiche Variationsbreite des β-Faktors für die Simulation der oben aufgeführten Kenngrößen des QD-SOA mit Hilfe des Ben-Ezra Ratengleichungsmodells, so ergeben sich eine Reihe signifikanter Verbesserungen, von denen nachfolgend vier näher beschrieben werden:

### 1. Verbesserte Verstärkung bei allen Leistungen

Stellt man die Verstärkung G als Funktion der optischen Ausgangsleistung Pout (siehe Figur 5) oder über der Stromdichte J (siehe Figur 8) dar, so erkennt man unmittelbar die gesteigerten Verstärkungswerte bei höheren β-Faktoren. Des weiteren zeigt sich ein für alle Verstärker typisches Plateau (linearer Verstärkerbereich) für niedrige Leistungen, gefolgt von einem starken Verstärkungsabfall (nichtlinearer Verstärkerbereich). Zur Abgrenzung des für den Betrieb geeigneten linearen vom nichtlinearen Verstärkerbereichs lässt sich die 3 dB-Sättigungsausgangsleistung -3dB Psat definieren, bei welcher die Verstärkung G um 3 dB gegenüber seinem Maximalwert reduziert wurde.

### 2. Deutlich erhöhte Sättigungsverstärkung

Bildet man die zugehörige 3dB Sättigungsverstärkung G(-3db Psat) (siehe Figur 6) als Funktion des β-Faktors ab, offenbart sich das Potential der Erfindung. Durch eine Erhöhung des β-Faktors aufgrund der Verwendung stark elongierter Quantenpunkte von 1,1 ‰ auf 1,5 ‰ lässt sich die Sättigungsverstärkung für den simulierten QD-SOA von 4.8 dB auf 8.5 dB steigern. Hierbei ist die logarithmische Natur der dB-Skala zu beachten. Die Steigungen um 3,7 dB entspricht einer prozentualen Steigerung des Verhältnisses der Ausgangsleistungen um 134 %.

## 3. Reduzierte Erholungszeit im oberen Betriebsbereich

Wie bereits erwähnt, ist neben der Verstärkung die Erholungszeit GRT (Gain Recovery Time) eine elementare Kenngröße für Verstärker aller Art. Sie beschreibt, wie schnell das System nach Verstärkung eines Pulses für eine erneute Verstärkung bereit steht und beschreibt damit die Grenze der maximalen Signalfrequenz. Aufgrund der kurzen Erholungszeiten von unter 1 ns stellt das Gebiet der Hochfrequenzsignalverstärkung die eigentliche Stärke der QD-SOAs dar. Betrachtet man den Einfluss des $\beta$-Faktors auf die Erholungszeit (siehe Figur 7), wird deutlich, dass sich für den weitaus größten Anteil des Betriebsbereiches, also Pout < Sättigungsausgangsleistung, keine Änderung erkennen lässt. Nähert man sich mit der Ausgangsleistung der Sättigungsausgangsleistung an, ist sogar zu erkennen, dass mit Hilfe der Elongation e eine weitere Reduktion der Erholungszeit möglich ist.

Abschließend lässt sich feststellen, dass QD-SOAs der oben beispielhaft beschriebenen Art durch ihre einmaligen Hochfrequenzeigenschaften überzeugen. Durch eine Elongation e von 3.0 lässt sich die Sättigungsverstärkung nahezu verdoppeln. Die Hochfrequenzeigenschaften werden dabei durch die Elongation je nach Signalleistung nicht beeinflusst oder können noch weiter verbessert werden.

Obwohl die Erfindung im Detail durch bevorzugte Ausführungsbeispiele näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

Bezugszeichenliste

10   Halbleiterverstärker
11   Halbleiterelement
20   Quantenpunktsäulenschicht
21   Quantenpunktschicht
22   Quantenpunktschicht
23   Quantenpunktschicht
24   Quantenpunktschicht
30   Substrat
200  Benetzungsschicht
210  Barriereschicht

A10   Ausgang
E10   Eingang
e     Elongation
G     Verstärkung
GRT   Erholungszeit
H     Höhe

I     Strom
J     Stromdichte
L     Länge
Lq    Länge
Lv    Länge
Pase  Leistung
Pout  optische Ausgangsleistung
Psig  Ausgangsleistung
QD    Quantenpunkt
QDS   Quantenpunktsäule
Sa    Strahlung
Se    Eingangsstrahlung
SVR   Strahlverstärkungsrichtung
VL    fiktive Verbindungslinie
X     Vorzugsrichtung
Y     Querrichtung

**Patentansprüche**

1. Optischer Halbleiterverstärker (10), bei dem eine Vielzahl an Quantenpunkten (QD) in zumindest einer Quantenpunktschicht (21-24) eines Halbleiterelements (11) des Halbleiterverstärkers (10) angeordnet sind, wobei das Halbleiterelement (11) eine in der Quantenpunktschichtebene liegende Vorzugsrichtung (X) aufweist und elongierte Quantenpunkte (QD) vorhanden sind, die jeweils in der genannten Vorzugsrichtung (X) länger sind als in einer dazu senkrechten und ebenfalls in der Quantenpunktschichtebene liegenden Querrichtung (Y),
**dadurch gekennzeichnet, dass**
die Strahlverstärkungsrichtung (SVR) des Halbleiterverstärkers (10), die durch eine fiktive Verbindungslinie (VL) zwischen einem zum Einstrahlen von Eingangsstrahlung (Se) dienenden Eingang (A10) des Halbleiterverstärkers (10) und einem zum Ausgeben der verstärkten Strahlung (Sa) dienenden Ausgang (A10) des Halbleiterverstärkers (10) festgelegt wird, parallel oder zumindest näherungsweise parallel zu der Querrichtung (Y) angeordnet ist.

2. Halbleiterverstärker (10) nach Anspruch 1,
**dadurch gekennzeichnet, dass**
bei mehr als 50 % der elongierten Quantenpunkte (QD) die Länge (Lv) in der Vorzugsrichtung (X) mindestens das 1,5-fache, vorzugsweise zwischen dem 1,8-fachen und dem 2,4-fachen, der Länge (Lq) der Quantenpunkte (QD) in der Querrichtung (Y) beträgt.

3. Halbleiterverstärker (10) nach einem der voranstehenden Ansprüche,
**dadurch gekennzeichnet, dass**

- mindestens zwei zueinander parallele Quantenpunktschichten (21-24) mit jeweils einer Vielzahl an elongierten Quantenpunkten (QD) vorhanden sind,
- die Quantenpunkte (QD) fluchtend übereinander liegen und
- die jeweils übereinander liegenden Quantenpunkte (QD) elongierte Quantenpunktsäulen (QDS) bilden.

4. Halbleiterverstärker (10) nach einem der voranstehenden Ansprüche,
**dadurch gekennzeichnet, dass**
die Quantenpunkte (QD) in den elongierten Quantenpunktsäulen (QDS) quantenmechanisch gekoppelt sind.

5. Halbleiterverstärker (10) nach einem der voranstehenden Ansprüche,
**dadurch gekennzeichnet, dass**
bei jeder der Quantenpunktschichten (21-24) jeweils mindestens 50 % der Quantenpunkte (QD) eine Länge (Lv) in der Vorzugsrichtung (X) aufweisen, die mindestens das 1,5-fache der Länge (Lq) der elongierten Quantenpunkte (QD) in der Querrichtung (Y) beträgt.

6. Halbleiterverstärker (10) nach einem der voranstehenden Ansprüche,
**dadurch gekennzeichnet, dass**
das Verhältnis zwischen der Höhe (H) der Quantenpunktsäulen (QDS) und der Länge (Lv) der Säulengrundfläche in Vorzugsrichtung (X) jeweils 1 beträgt oder zumindest in einem Bereich zwischen 0,9 und 1,1 liegt.

7. Halbleiterverstärker (10) nach einem der voranstehenden Ansprüche,
**dadurch gekennzeichnet, dass**
sich die Längsrichtung der Quantenpunktsäulen (QDS) in der [001]-Richtung erstreckt.

8. Halbleiterverstärker (10) nach einem der voranstehenden Ansprüche,
**dadurch gekennzeichnet, dass**

- die Vorzugsrichtung (X) die [1$\bar{1}$0] -Kristallrichtung der Quantenpunktschicht oder Quantenpunktschichten ist, und
- die Querrichtung (Y) die [110]-Kristallrichtung der Quantenpunktschicht oder Quantenpunktschichten ist.

9. Verfahren zum Herstellen eines optischen Halbleiterverstärkers (10), insbesondere zum Herstellen eines optischen Halbleiterverstärkers (10) nach einem der voranstehenden Ansprüche, wobei bei dem Verfahren eine Vielzahl an Quantenpunkten (QD) hergestellt wird, indem Quantenpunktmaterial auf einer Schicht des Halbleiterelements (11) aufgebracht wird und eine Strahlverstärkungsrichtung (SVR) des Halbleiterverstärkers (10) durch eine fiktive Verbindungslinie (VL) zwischen einem zum Einstrahlen von Eingangsstrahlung (Se) dienenden Eingang (A10) des Halbleiterverstärkers (10) und einem zum Ausgeben der verstärkten Strahlung (Sa) dienenden Ausgang (A10) des Halbleiterverstärkers (10) festgelegt wird, **dadurch gekennzeichnet, dass**

- die Mehrzahl der Quantenpunkte (QD) als elongierte Quantenpunkte (QD) hergestellt werden, die in einer in der Quantenpunktschichtebene liegenden Vorzugsrichtung (X) des Halbleiterelements (11) länger als in einer dazu senkrechten und ebenfalls in der Quantenpunktschichtebene liegenden Querrichtung (Y) sind, und
- die Strahlverstärkungsrichtung (SVR) parallel oder zumindest näherungsweise parallel zu dieser Querrichtung (Y) angeordnet wird.

10. Verfahren nach einem der voranstehenden Ansprüche,
**dadurch gekennzeichnet, dass**

- Quantenpunktmaterial zur Bildung der Quantenpunkte (QD) mittelbar oder unmittelbar auf ein (001)-Substrat (30) aufgewachsen wird und als Wachstumsrichtung beim Aufbringen des Quantenpunktmaterials die [001]-Kristallrichtung ausgewählt wird,
- die Vorzugsrichtung (X) des Halbleiterelements (11) die [1$\bar{1}$0] -Kristallrichtung ist und
- die Querrichtung (Y) die [110]-Kristallrichtung ist.

11. Verfahren nach einem der voranstehenden Ansprüche,
**dadurch gekennzeichnet, dass**

- eine Quantenpunktsäulenschicht (20) mit mindestens zwei zueinander parallelen Quantenpunktschichten (21-24) mit jeweils einer Vielzahl an elongierten Quantenpunkten (QD) hergestellt wird, und
- die Quantenpunkte (QD) fluchtend übereinander aufgewachsen werden und die jeweils übereinander liegenden Quantenpunkte (QD) entlang der Vorzugsrichtung (X) elongierte Quantenpunktsäulen (QDS) bilden.

12. Verfahren nach einem der voranstehenden Ansprüche,
**dadurch gekennzeichnet, dass**
die Quantenpunkte (QD) in den elongierten Quantenpunktsäulen (QDS) ohne Abstand oder allenfalls mit einem so kleinen Abstand zueinander hergestellt werden, dass übereinander liegende Quantenpunkte (QD) quantenmechanisch gekoppelt sind.

**13.** Verfahren nach einem der voranstehenden Ansprüche,

**dadurch gekennzeichnet, dass**

die Quantenpunkte (QD) in den elongierten Quantenpunktsäulen (QDS) unmittelbar aufeinander aufgewachsen werden, so dass sich diese berühren.

**14.** Verfahren nach einem der voranstehenden Ansprüche,

**dadurch gekennzeichnet, dass**

das Verhältnis zwischen der Höhe (H) der Quantenpunktsäulen (QDS) und der Länge (Lv) der Säulengrundfläche in Vorzugsrichtung (X) auf einen Wert von 1 oder zumindest auf einen Wert im Bereich zwischen 0,9 und 1,1 eingestellt wird.

**15.** Verfahren zum Betreiben eines optischen Halbleiterverstärkers (10) nach einem der voranstehenden Ansprüche 1 bis 7 oder eines nach einem der voranstehenden Ansprüche 8 bis 14 hergestellten Halbleiterverstärkers (10),

**dadurch gekennzeichnet, dass**

optische Strahlung (Sa) an dem Eingang (A10) des Halbleiterverstärkers (10) entlang einer Richtung mit einem Fehlwinkel von weniger als 30° bezogen auf die Querrichtung der elongierten Quantenpunkte eingestrahlt wird und die verstärkte Strahlung (Sa) entlang dieser Strahlrichtung am Ausgang (A10) des Halbleiterverstärkers (10) aus diesem ausgekoppelt wird.

Fig.1

EP 3 648 265 A1

Z,[001]

Y, [110]

X,[1̄10]

SVR

QDS    QD    QDS    QDS    QDS

Se    20

H

Lq

(001)    200    210

24
23
22
21

Sa

10

L

30

Fig.2

Fig.3

EP 3 648 265 A1

Fig.4

Fig.5

Fig.6

Fig.7

EP 3 648 265 A1

Fig.8

EP 3 648 265 A1

Europäisches
Patentamt

European
Patent Office

Office européen
des brevets

**EUROPÄISCHER RECHERCHENBERICHT**

Nummer der Anmeldung

EP 18 20 3957

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X,D | EP 1 354 338 B1 (STC UNM [US]) 14. November 2012 (2012-11-14) * das ganze Dokument * ----- | 1-15 | INV. H01S5/12 H01S5/34 H01S5/50 |
| A | US 2011/140084 A1 (HATORI NOBUAKI [JP]) 16. Juni 2011 (2011-06-16) * Absätze [0002] - [0049]; Abbildungen 5,6 * ----- | 1-15 | |
| A | DE 10 2006 010277 A1 (FUJITSU LTD [JP]; UNIV TOKYO [JP]) 5. Oktober 2006 (2006-10-05) * das ganze Dokument * ----- | 1-15 | |
| A | WO 2014/038211 A1 (NAT UNIV CORP UNIV KOBE [JP]) 13. März 2014 (2014-03-13) * Zusammenfassung; Abbildungen 1-2 * ----- | 1 | |
| A,P | L. Greif, S. Jagsch, M. Wagner, A. Schliwa: "Tuning the Emission Directionality of Stacked Quantum Dots", ACS Photonics, 2. November 2018 (2018-11-02), Seiten 4838-4845, XP002790356, DOI: 10.1021/acsphotonics.8b00956 Gefunden im Internet: URL:https://www.researchgate.net/profile/Markus_Wagner4/publication/328710768_Tuning_the_Emission_Directionality_of_Stacked_Quantum_Dots/links/5c152defa6fdcc494ff7b70e/Tuning-the-Emission-Directionality-of-Stacked-Quantum-Dots.pdf?origin=publication_detail [gefunden am 2019-04-03] * das ganze Dokument * ----- | 1-15 | RECHERCHIERTE SACHGEBIETE (IPC) H01S B82Y |

Der vorliegende Recherchenbericht wurde für alle Patentansprüche erstellt

| Recherchenort | Abschlußdatum der Recherche | Prüfer |
|---|---|---|
| Den Haag | 4. April 2019 | But, Gabriela-Ileana |

EPO FORM 1503 03.82 (P04C03)

**ANHANG ZUM EUROPÄISCHEN RECHERCHENBERICHT
ÜBER DIE EUROPÄISCHE PATENTANMELDUNG NR.**

EP 18 20 3957

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

04-04-2019

| Im Recherchenbericht angeführtes Patentdokument | Datum der Veröffentlichung | Mitglied(er) der Patentfamilie | Datum der Veröffentlichung |
|---|---|---|---|
| EP 1354338 B1 | 14-11-2012 | AU 1297302 A<br>CA 2424468 A1<br>EP 1354338 A2<br>IL 154997 A<br>JP 4047718 B2<br>JP 2004525498 A<br>JP 2007116200 A<br>US 2002079485 A1<br>WO 0225705 A2 | 02-04-2002<br>28-03-2002<br>22-10-2003<br>01-08-2006<br>13-02-2008<br>19-08-2004<br>10-05-2007<br>27-06-2002<br>28-03-2002 |
| US 2011140084 A1 | 16-06-2011 | JP 2011124479 A<br>US 2011140084 A1 | 23-06-2011<br>16-06-2011 |
| DE 102006010277 A1 | 05-10-2006 | DE 102006010277 A1<br>JP 4737745 B2<br>JP 2006245373 A<br>US 2006220001 A1 | 05-10-2006<br>03-08-2011<br>14-09-2006<br>05-10-2006 |
| WO 2014038211 A1 | 13-03-2014 | JP WO2014038211 A1<br>WO 2014038211 A1 | 08-08-2016<br>13-03-2014 |

EPO FORM P0461

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 1354338 B1